# EUROPEAN PATENT APPLICATION

(11) **EP 4 730 596 A1**
(43) Date of publication of application: **22.04.2026**
(21) Application number: 24907861.9
(22) Date of filing: 28.11.2024
(51) Int. Cl.: H02J 7/00, G01R 31/382, G01R 31/389, H01M 10/44, H01M 10/48, H01M 10/637, H01M 10/6567

(54) **APPARATUS AND METHOD FOR SETTING CHARGING PROTOCOL**

(30) Priority: 22.12.2023 KR 20230190291
(71) Applicant: LG Energy Solution, Ltd., Seoul 07335 (KR)
(72) Inventor: AN, Ji-Su, Daejeon 34122 (KR); LEE, Ji-Eun, Daejeon 34122 (KR); YU, Jeong-In, Daejeon 34122 (KR); WHANG, Tae-Kyung, Daejeon 34122 (KR)
(74) Representative: Goddar, Heinz J.
(86) International application number: PCT/KR2024/019180
(87) International publication number: WO 2025/135576

(57) **Abstract**

A charging protocol setting apparatus according to an embodiment of the present disclosure includes a charging unit configured to charge a battery so that the battery repeats a charging state and a rest state; a measuring unit configured to measure a voltage of the battery while the battery is being charged; a temperature adjusting unit configured to adjust a temperature of the battery while the battery is being charged; and a control unit configured to control the charging unit so that the battery is charged at a preset first C-rate, calculate a resistance of the battery at each SOC (State of Charge) based on a voltage drop in the rest state, determine a first charging upper limit SOC corresponding to the first C-rate based on the SOC and the resistance, and set a charging protocol including a corresponding relationship between the first C-rate and the first charging upper limit SOC.

## Description

### TECHNICAL FIELD

This application is based on and claims priority from Korean Patent Application No. 10-2023-0190291, filed on December 22, 2023, with the Korean Intellectual Property Office, the disclosure of which is incorporated herein in its entirety by reference.

The present disclosure relates to a charging protocol setting apparatus and method, and more specifically, to a charging protocol setting apparatus and method for setting a charging protocol of a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

As electric vehicles, electric motorcycles, and electric bicycles, etc., are commercialized, the demand for high-capacity and high-performance batteries is increasing. However, as the capacity of the battery increases, the time required to charge the battery also increases, which is a disadvantage. To solve this problem, a technology for rapidly charging batteries is being developed, but there is a concern that rapid charging may accelerate battery deterioration. Therefore, in order to prevent battery deterioration due to rapid charging, a rapid charging protocol that may efficiently charge the battery is required.

### DISCLOSURE

### Technical Problem

The present disclosure is designed to solve the problems of the related art, and therefore the present disclosure is directed to providing a charging protocol setting apparatus and method for setting a charging protocol.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A charging protocol setting apparatus according to one aspect of the present disclosure may comprise a charging unit configured to charge a battery so that the battery repeats a charging state and a rest state; a measuring unit configured to measure a voltage of the battery while the battery is being charged; a temperature adjusting unit configured to adjust a temperature of the battery while the battery is being charged; and a control unit configured to control the charging unit so that the battery is charged at a preset first C-rate, calculate a resistance of the battery at each SOC (State of Charge) based on a voltage drop in the rest state, determine a first charging upper limit SOC corresponding to the first C-rate based on the SOC and the resistance, and set a charging protocol including a corresponding relationship between the first C-rate and the first charging upper limit SOC.

The control unit may be configured to control the charging unit so that the battery is charged at a second C-rate different from the first C-rate, determine a second charging upper limit SOC corresponding to the second C-rate for the battery, and include a corresponding relationship between the second C-rate and the second charging upper limit SOC in the charging protocol.

The second charging upper limit SOC may be configured to be lower than the first charging upper limit SOC when the first C-rate is lower than the second C-rate.

The second charging upper limit SOC may be configured to exceed the first charging upper limit SOC when the first C-rate exceeds the second C-rate.

The temperature adjusting unit may be configured to flow a cooling medium so that the temperature of the battery is maintained at a preset threshold temperature or below.

The measuring unit may be configured to further measure a temperature of the battery.

The temperature adjusting unit may be configured to increase at least one of an amount and a flow rate of the cooling medium as the temperature of the battery approaches the threshold temperature.

The control unit may be configured to set a resistance profile representing a corresponding relationship between the resistance and the SOC, select a target point satisfying a predetermined condition in the resistance profile, and determine a SOC corresponding to the selected target point as the first charging upper limit SOC.

The control unit may be configured to select a feature point with a largest corresponding SOC among feature points included in the resistance profile as the target point.

The control unit may be configured to determine a maximum point included in the resistance profile as the feature point.

The control unit may be configured not to determine the first charging upper limit SOC when there is no target point satisfying the predetermined condition in the resistance profile.

A charging control device according to another aspect of the present disclosure may be configured to control charging of a battery to be charged based on the charging protocol set by the charging protocol setting apparatus according to an aspect of the present disclosure.

A battery pack according to still another aspect of the present disclosure may comprise the charging control device according to another aspect of the present disclosure.

A vehicle according to still another aspect of the present disclosure may comprise the charging control device according to another aspect of the present disclosure.

A charging protocol setting method according to still another aspect of the present disclosure may comprise a SOC-based resistance calculating step of calculating a resistance of a battery at each SOC based on a voltage drop in a rest state while the battery is being charged by repeating a charging state and the rest state at a preset first C-rate; a charging upper limit SOC determining step of determining a first charging upper limit SOC corresponding to the first C-rate based on the SOC and the resistance; and a charging protocol setting step of setting a charging protocol including a corresponding relationship between the first C-rate and the first charging upper limit SOC.

The charging protocol setting method according to still another aspect of the present disclosure may be configured to perform the SOC-based resistance calculating step, the charging upper limit SOC determining step, and the charging protocol setting step based on a second C-rate different from the first C-rate, so that a corresponding relationship between the second C-rate and a second charging upper limit SOC corresponding to the second C-rate is included in the charging protocol.

### Advantageous Effects

According to one aspect of the present disclosure, by preventing battery degradation due to charging, the battery may be safely charged and the expected lifespan of the battery may be increased.

That is, the charging protocol setting apparatus has the advantage of being able to set a charging protocol that may increase the expected life of the battery by preventing unnecessary degradation of the battery.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing a charging protocol setting apparatus according to an embodiment of the present disclosure.
FIG. 2 is a drawing schematically showing a charging process according to an embodiment of the present disclosure.
FIG. 3 is a drawing schematically showing an example of resistance at each SOC of a first battery according to an embodiment of the present disclosure.
FIG. 4 is a drawing schematically showing an example of temperature at each SOC of the first battery according to an embodiment of the present disclosure.
FIG. 5 is a schematic drawing showing a comparison example of resistance at each SOC of a second battery according to an embodiment of the present disclosure.
FIG. 6 is a schematic drawing showing a comparison example of temperature at each SOC of the second battery according to an embodiment of the present disclosure.
FIG. 7 is a schematic drawing showing a first charging protocol and a second charging protocol according to an embodiment of the present disclosure.
FIG. 8 is a diagram schematically showing a charging control device according to another embodiment of the present disclosure.
FIG. 9 is a diagram schematically showing a battery pack according to still another embodiment of the present disclosure.
FIG. 10 is a diagram schematically showing a charging device according to still another embodiment of the present disclosure.
FIG. 11 is a diagram schematically showing a vehicle according to still another embodiment of the present disclosure.
FIG. 12 is a diagram schematically showing a charging protocol setting method according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

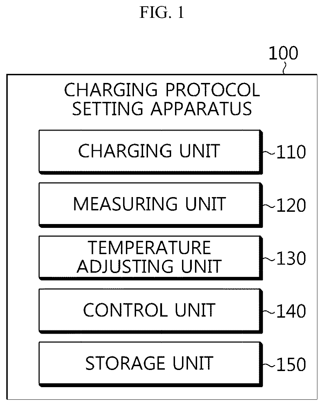

FIG. 1 is a diagram schematically illustrating a charging protocol setting apparatus 100 according to an embodiment of the present disclosure.

Referring to FIG. 1, the charging protocol setting apparatus 100 may include a charging unit 110, a measuring unit 120, a temperature adjusting unit 130, and a control unit 140.

The charging unit 110 may be configured to charge a battery so that the battery repeats a charging state and a rest state.

Here, the battery refers to an independent cell that has a negative terminal and a positive terminal and is physically separable. As an example, a lithium-ion battery or a lithium polymer battery may be considered as a battery. In addition, the type of batteries may be a cylindrical type, a prismatic type or a pouch type. Additionally, the battery may mean a battery bank, a battery module or a battery pack in which a plurality of cells are connected in series and/or parallel. Below, for convenience of explanation, the battery is explained as meaning one independent cell.

Specifically, the charging unit 110 may charge the battery with constant current (CC) and/or constant power (CP). For example, when the charging unit 110 receives a charging command for the battery from the control unit 140, the charging unit 110 may charge the battery. Here, the charging command may include C-rate information for charging. For example, when C-rate information for 1 C is included in the charging command, the charging unit 110 may charge the battery at 1 C.

Also, the charging unit 110 may enter a rest state during charging. Here, the rest state is a state in which charging is stopped. For example, when the charging unit 110 is in a rest state, the battery is in a no-load state. That is, in the charging process of the battery, the charging period and the rest period may be repeated.

Preferably, the charging unit 110 may enter a rest state whenever the SOC (State of Charge) of the battery increases by a preset unit SOC. Here, the rest period may be a preset unit time.

For example, the charging unit 110 may maintain a rest state for 1 second whenever the SOC of the battery increases by 1%. Afterwards, the charging unit 110 may charge the battery again until the SOC of the battery increases by 1%.

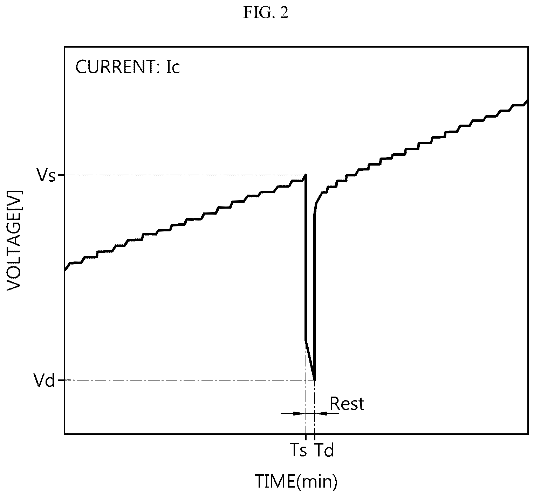

FIG. 2 is a drawing schematically showing a charging process according to an embodiment of the present disclosure.

In the embodiment of FIG. 2, the charging unit 110 may charge the battery. Here, the charging current is Ic. The charging unit 110 is in a charging state before Ts and after Td, and is in a rest state during Ts to Td. That is, the charging period is a period before Ts and a period after Td, and the rest period is a period from Ts to Td. During the rest period, the voltage of the battery may decrease from Vs to Vd. Thereafter, as the state of the charging unit 110 is switched to the charging state, the voltage of the battery may increase again.

The measuring unit 120 may be configured to measure the voltage of the battery while the battery is being charged.

Specifically, the measuring unit 120 may measure the voltage across the battery. The measuring unit 120 may be connected to the positive terminal of the battery to measure the positive voltage, and may be connected to the negative terminal of the battery to measure the negative voltage. In addition, the measuring unit 120 may measure the voltage of the battery by calculating the difference between the positive voltage and the negative voltage.

For example, the measuring unit 120 may measure the voltage of the battery according to a preset voltage measurement cycle. Additionally, the measuring unit 120 may measure the voltage of the battery in a no-load state when the charging unit 110 is in a rest state.

Preferably, the measuring unit 120 may measure the voltage of the battery during the charging period according to a preset voltage measurement cycle. Also, the measuring unit 120 may measure the voltage of the battery at the start point and the end point of the rest period.

For example, in the embodiment of FIG. 2, the measuring unit 120 may measure the voltage of the battery according to a preset voltage measurement cycle during the charging period (the period before Ts and the period after Td). Then, the measuring unit 120 may measure the voltage of the battery as Vs [V] at Ts, which is the start point of the rest period, and measure the voltage of the battery as Vd [V] at Td, which is the end point of the rest period.

The temperature adjusting unit 130 may be configured to adjust the temperature of the battery while the battery is being charged.

Specifically, the temperature adjusting unit 130 may be configured to flow a cooling medium so that the temperature of the battery is maintained at a preset threshold temperature or below. For example, the temperature adjusting unit 130 may maintain the temperature of the battery at a threshold temperature or below by flowing at least one of coolant, antifreeze, insulating oil, and cooling gas.

Preferably, the temperature adjusting unit 130 may maintain the temperature of the battery at the threshold temperature or below during the charging process of the battery. For example, during the charging process of the battery, the charging unit 110 may repeat a charging state and a rest state, but the temperature adjusting unit 130 may maintain the temperature of the battery at the threshold temperature or below even when the charging unit 110 is in the rest state.

For example, in the embodiment of FIG. 2, the temperature adjusting unit 130 may flow a cooling medium so that the temperature of the battery is maintained at the threshold temperature or below at time points before Ts, between Ts and Td, and after Td.

Meanwhile, as long as the temperature adjusting unit is able to control the temperature of the battery through a cooling medium, the structure, shape, connection relationship with the battery, etc. of the temperature adjusting unit are not particularly limited.

The control unit 140 may be configured to control the charging unit 110 so that the battery is charged at a preset first C-rate.

Specifically, the control unit 140 may transmit a charging command to the charging unit 110. Here, the charging command may include C-rate information.

The control unit 140 may be configured to calculate the resistance of the battery according to SOC based on the voltage drop at the rest state.

Specifically, the control unit 140 may be connected to the measuring unit 120 to enable wired and/or wireless communication. The control unit 140 may receive voltage information about the battery from the measuring unit 120.

Also, the control unit 140 may calculate the resistance of the battery according to the voltage drop based on the received voltage information. That is, the control unit 140 may calculate the resistance of the battery based on the voltage drop during the rest period. Specifically, the control unit 140 may calculate the resistance of the battery whenever the charging unit 110 enters the rest state.

For example, the control unit 140 may calculate the resistance of the battery by considering the charging current and the voltage drop during the rest period. Assuming that the charging unit 110 enters the rest state whenever the SOC of the battery increases by 1%, the control unit 140 may calculate the resistance corresponding to each SOC of the battery.

For example, in the embodiment of FIG. 2, the voltage drop is Vs - Vd and the charging current is Ic. The control unit 140 may calculate the formula "(Vs - Vd) ÷ Ic" to derive the resistance corresponding to the SOC.

The control unit 140 may be configured to determine a first charging upper limit SOC corresponding to the first C-rate based on the SOC and resistance.

Specifically, the control unit 140 may be configured to set a resistance profile representing a corresponding relationship between resistance and SOC. Here, the resistance profile is a profile representing a corresponding relationship between SOC and resistance. For example, when the X-axis is set to SOC and the Y-axis is set to resistance, the resistance profile may be expressed as a two-dimensional graph.

The control unit 140 may be configured to select a target point that satisfies a predetermined condition in the resistance profile. Here, the target point is a point that satisfies a predetermined condition in the resistance profile, and the SOC of the target point may be determined as a charging upper limit SOC corresponding to the first C-rate.

Specifically, the control unit 140 may be configured to select a feature point with the largest corresponding SOC among the feature points included in the resistance profile as a target point.

More specifically, the control unit 140 may be configured to determine a maximum point included in the resistance profile as a feature point. Here, the maximum point is a point in the resistance profile where the instantaneous change rate of resistance with respect to SOC is 0 and which has an upward convex shape. That is, the slope of the SOC immediately before the maximum point is positive, and the slope of the SOC immediately after the maximum point is negative. That is, the control unit 140 may select a feature point with the largest SOC among at least one maximum point included in the resistance profile as a target point.

Preferably, the resistance profile may include one or more feature points. Also, the control unit 140 may select a target point among one or more feature points included in the resistance profile.

For example, if the resistance profile includes one feature point, the control unit 140 may select the feature point as the target point.

As another example, when the resistance profile includes multiple feature points, the control unit 140 may select a feature point with the largest corresponding SOC among the multiple feature points as the target point.

The control unit 140 may be configured to determine the SOC corresponding to the selected target point as the first charging upper limit SOC. Here, the first charging upper limit SOC means the charging end SOC of the battery when the battery is charged at the first C-rate.

In general, in a rapid charging process, a lithium plating phenomenon may occur due to a non-uniform reaction within the battery, in which lithium metal is precipitated. In particular, the target point of the resistance profile is a point where the resistance of the battery decreases, and the decrease in the resistance of the battery is due to the precipitation of lithium metal. In other words, the target point of the resistance profile may be viewed as a point where lithium plating starts. Therefore, the first charging upper limit SOC, which is the SOC of the target point, means the charging upper limit SOC in the first C-rate charge or the charging end SOC.

The control unit 140 may be configured to set a charging protocol including a corresponding relationship between the first C-rate and the first charging upper limit SOC.

Specifically, the control unit 140 may set a charging protocol by mapping the first C-rate and the first charging upper limit SOC. That is, the charging protocol may include mapping information of the first C-rate and the first charging upper limit SOC.

For example, when the battery is charged at the first C-rate according to the charging protocol, charging of the battery may be terminated when the SOC of the battery reaches the first charging upper limit SOC.

The charging protocol setting apparatus 100 according to an embodiment of the present disclosure may effectively prevent lithium plating from occurring during a charging process by determining a charging upper limit SOC for each C-rate. Accordingly, battery degradation due to charging is prevented, so that the battery may be safely charged, and the expected lifespan of the battery may be increased.

Meanwhile, the control unit 140 included in the charging protocol setting apparatus 100 may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the control unit 140 may be implemented as a set of program modules. At this time, the program module may be stored in the memory and executed by the control unit 140. The memory may be inside or outside the control unit 140 and may be connected to the control unit 140 by various well-known means.

In addition, the charging protocol setting apparatus 100 may further include a storage unit 150. The storage unit 150 may store data necessary for operation and function of each component of the charging protocol setting apparatus 100, data generated in the process of performing the operation or function, or the like. The storage unit 150 is not particularly limited in its kind as long as it is a known information storage means that can record, erase, update and read data. As an example, the information storage means may include RAM, flash memory, ROM, EEPROM, registers, and the like. In addition, the storage unit 150 may store program codes in which processes executable by the control unit 140 are defined.

For example, the voltage information, the resistance profile, and the charging protocol of the battery may be stored in the storage unit 150.

Specifically, the control unit 140 may set a charging protocol corresponding to multiple C-rates. That is, the control unit 140 may set a charging protocol indicating a corresponding relationship between multiple C-rates and multiple charging upper limit SOCs.

The control unit 140 may be configured to control the charging unit 110 so that the battery is charged at a second C-rate that is different from the first C-rate.

Preferably, the control unit 140 may transmit a charging command to the charging unit 110 so that the battery is charged at the second C-rate after the charging protocol according to the first C-rate is set. The charging unit 110, which receives the charging command, may charge the battery at the second C-rate by repeating the charging state and the rest state.

For example, when a charging protocol according to the first C-rate is set, the battery may be in a fully charged state. Here, the fully charged state means a state in which the battery is fully charged until the SOC of the battery reaches a preset charging end SOC or SOC 100%. Accordingly, the battery may be discharged until the SOC of the battery reaches a preset discharge end SOC or SOC 0%. In one embodiment, the battery may go through a rest period of a predetermined period (e.g., 30 minutes) after the discharge is finished and then become a stable state. Thereafter, the battery may be charged at the second C-rate.

The control unit 140 may be configured to determine a second charging upper limit SOC corresponding to the second C-rate for the battery.

The control unit 140 may generate a resistance profile representing a corresponding relationship between the SOC and resistance of the battery. In addition, the control unit 140 may select a target point from the resistance profile and determine the SOC of the selected target point as the second charging upper limit SOC.

The control unit 140 may be configured to include a corresponding relationship between the second C-rate and the second charging upper limit SOC in the charging protocol.

Preferably, the size of the C-rate and the charging upper limit SOC may be inversely proportional. That is, as the C-rate increases, the corresponding charging upper limit SOC may decrease. Conversely, as the C-rate decreases, the corresponding charging upper limit SOC may increase.

For example, if the first C-rate is lower than the second C-rate, the second charging upper limit SOC may be lower than the first charging upper limit SOC. Conversely, if the first C-rate exceeds the second C-rate, the second charging upper limit SOC may exceed the first charging upper limit SOC.

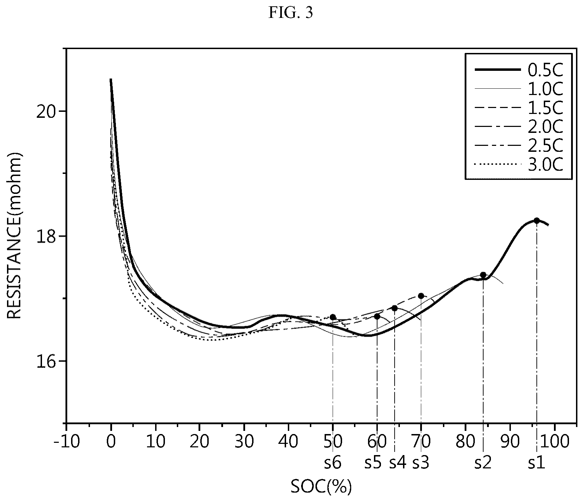

FIG. 3 is a drawing schematically showing an example of resistance at each SOC of a first battery according to an embodiment of the present disclosure. Specifically, FIG. 3 is a diagram drawing six resistance profiles set by charging the first battery at 0.5 C, 1 C, 1.5 C, 2 C, 2.5 C, and 3 C, respectively.

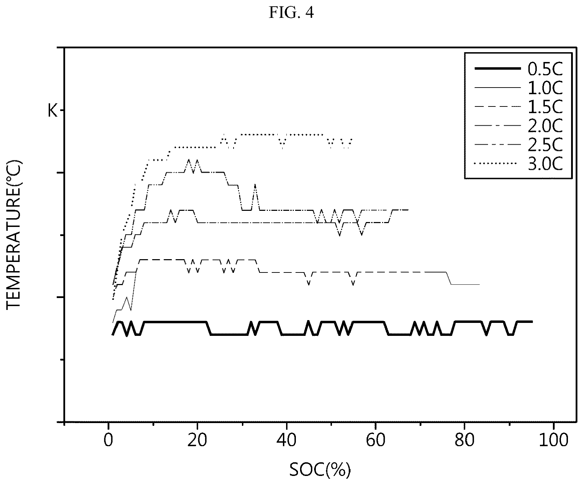

FIG. 4 is a drawing schematically showing an example of temperature at each SOC of the first battery according to an embodiment of the present disclosure. Specifically, the temperature adjusting unit 130 may adjust the temperature of the first battery so that the temperature of the first battery is maintained at the threshold temperature (K) or below during the charging process of the first battery. Therefore, during the charging process according to each C-rate, the temperature of the first battery is maintained at the threshold temperature (K) or below.

In the embodiment of FIG. 3, the target point of each resistance profile is a point indicated by "●". When the first battery is charged at 0.5 C, the SOC of the target point is s1, so the charging upper limit SOC corresponding to 0.5 C is s1. When the first battery is charged at 1 C, the SOC of the target point is s2, so the charging upper limit SOC corresponding to 1 C is s2. When the first battery is charged at 1.5 C, the SOC of the target point is s3, so the charging upper limit SOC corresponding to 1.5 C is s3. When the first battery is charged at 2 C, the SOC of the target point is s4, so the charging upper limit SOC corresponding to 2 C is s4. When the first battery is charged at 2.5 C, the SOC of the target point is s5, so the charging upper limit SOC corresponding to 2.5 C is s5. When the first battery is charged at 3 C, the SOC of the target point is s6, so the charging upper limit SOC corresponding to 3 C is s6.

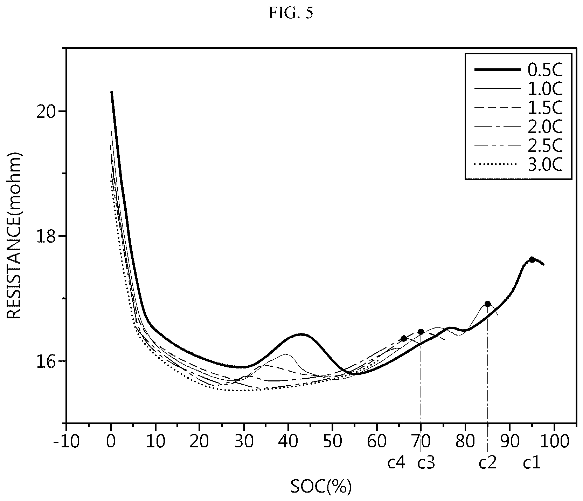

FIG. 5 is a schematic drawing showing a comparison example of resistance at each SOC of a second battery according to an embodiment of the present disclosure. Specifically, FIG. 5 is a diagram showing six resistance profiles set by charging the second battery at 0.5 C, 1 C, 1.5 C, 2 C, 2.5 C, and 3 C, respectively.

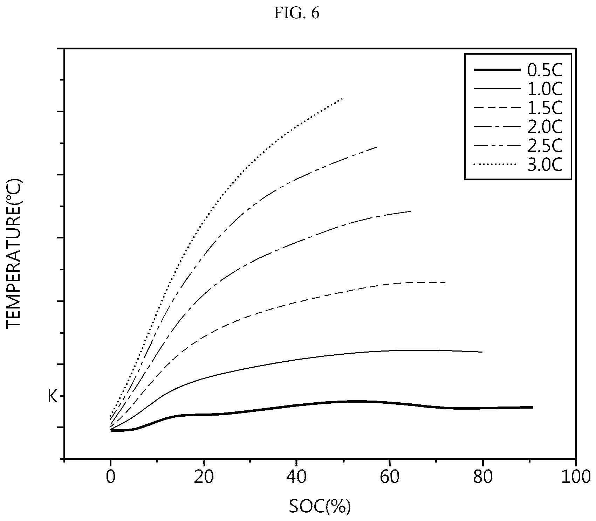

FIG. 6 is a schematic drawing showing a comparison example of temperature at each SOC of the second battery according to an embodiment of the present disclosure. Specifically, the temperature of the second battery, unlike the first battery, is not regulated to be maintained at the threshold temperature (K) or below during the charging process. Therefore, the higher the C-rate, the higher the temperature measured at each SOC.

In the comparison example of FIG. 5, the target point of each resistance profile is a point indicated by "●". When the second battery is charged at 0.5 C, the SOC of the target point is c1, so the charging upper limit SOC corresponding to 0.5 C is c1. When the second battery is charged at 1 C, the SOC of the target point is c2, so the charging upper limit SOC corresponding to 1 C is c2. When the second battery is charged at 1.5 C, the SOC of the target point is c3, so the charging upper limit SOC corresponding to 1.5 C is c3. When the second battery is charged at 2 C, the SOC of the target point is c4, so the charging upper limit SOC corresponding to 2 C is c4. When the second battery is charged at 2.5 C or 3C, the charging upper limit SOC is not determined because the target point does not exist.

Specifically, if the temperature of the battery is not controlled during the charging process of the battery, the battery resistance may increase due to heat generation. In addition, since the temperature of the battery may continue to increase due to the heat generation of the battery, the resistance of the battery may also continue to increase as the charging progresses. That is, the target point is selected as one of the feature points (e.g., the maximum point) included in the resistance profile, but if the resistance continues to increase due to the heat generation of the battery, the feature point may not exist. Therefore, if the temperature is not controlled during the charging process of the battery, the feature point may not be included in the resistance profile.

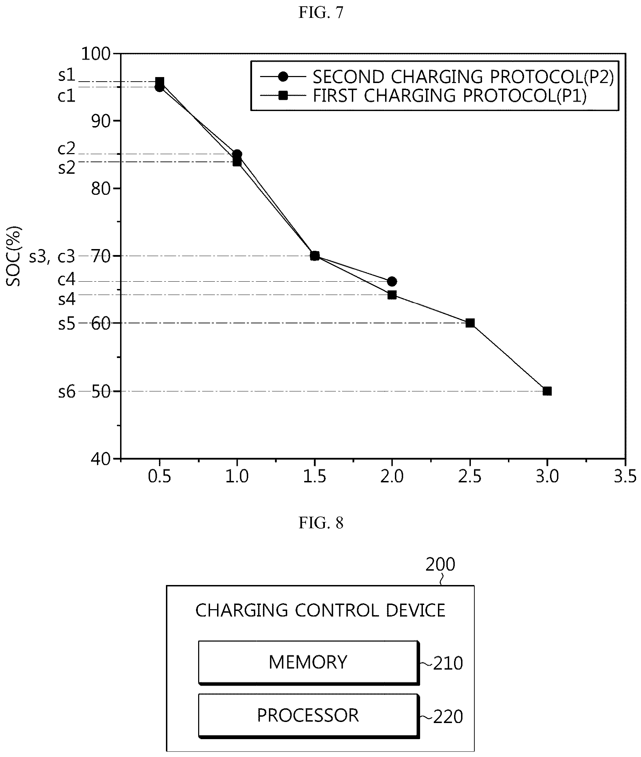

FIG. 7 is a schematic drawing showing a first charging protocol P1 and a second charging protocol P2 according to an embodiment of the present disclosure. Specifically, the first charging protocol P1 is a charging protocol set for the first battery, and the second charging protocol P2 is a charging protocol set for the second battery. Since the second charging protocol P2 includes a charging upper limit SOC affected by the heat generation of the second battery, it does not include a charging upper limit SOC corresponding to 2.5 C and 3 C.

In addition, at 0.5 C, 1 C, and 2 C, the charging upper limit SOC included in the first charging protocol P1 and the second charging protocol P2 are different. Specifically, at 0.5 C, the charging upper limit SOC according to the first charging protocol P1 is s1, and the charging upper limit SOC according to the second charging protocol P2 is c1. At 1 C, the charging upper limit SOC according to the first charging protocol P1 is s2, and the charging upper limit SOC according to the second charging protocol P2 is c2. At 1.5 C, the charging upper limit SOC according to the first charging protocol P1 is s3, and the charging upper limit SOC according to the second charging protocol P2 is c3.

The charging protocol setting apparatus 100 according to an embodiment of the present disclosure may determine a charging upper limit SOC for each C-rate with the minimized influence of heat generation of the battery by maintaining the temperature of the battery at a threshold temperature or below during a charging process. Accordingly, since an optimal charging upper limit SOC at which lithium is not precipitated may be determined for each C-rate, the battery may be safely charged according to the charging protocol set by the charging protocol setting apparatus 100.

Meanwhile, the measuring unit 120 may be configured to further measure the temperature of the battery.

The temperature adjusting unit 130 may be configured to increase at least one of the amount and the flow rate of the cooling medium as the temperature of the battery approaches a threshold temperature.

Specifically, since the temperature of the battery rises during the charging process, it may not be possible to maintain the temperature of the battery at the threshold temperature or below by controlling the temperature to be maintained at a constant level.

For example, in the comparison example of FIG. 5, if the temperature of the battery is not controlled in the charging process, the temperature of the battery may continuously increase. In particular, the temperature increase in the low SOC section is steeper than that in the high SOC section. In other words, the temperature increase rate in the low SOC section is greater than the temperature increase rate in the high SOC section.

Accordingly, the temperature adjusting unit 130 may be configured to increase at least one of the amount and the flow rate of the cooling medium as the temperature of the battery approaches the threshold temperature. That is, the temperature adjusting unit 130 may increase the total amount of the cooling medium so that more cooling medium may affect the battery, or may increase the flow rate of the cooling medium so that the cooling medium may affect the battery more frequently.

For example, it is assumed that the temperature adjusting unit 130 controls the temperature of the battery through the cooling medium. The temperature adjusting unit 130 may control the temperature of the battery at the threshold temperature or below by increasing the amount and/or the flow rate of the cooling medium as the temperature of the battery approaches the threshold temperature.

As another example, the temperature adjusting unit 130 may control the temperature of the battery by adding cooling gas while controlling the temperature of the battery using the cooling medium.

The charging protocol setting apparatus 100 may set a charging protocol that minimizes the influence of heat generation by controlling the temperature of the battery during the charging process. Therefore, since the battery may be safely charged according to the charging protocol set by the charging protocol setting apparatus 100, unintentional deterioration of the battery due to charging may be prevented. That is, the charging protocol setting apparatus 100 has an advantage of setting a charging protocol that may increase the expected life of the battery by preventing unnecessary deterioration of the battery.

Meanwhile, the control unit 140 may be configured not to determine the first charging upper limit SOC if there is no target point satisfying a predetermined condition in the resistance profile.

When the temperature adjusting unit 130 adjusts the temperature of the battery, the resistance profile generated by the control unit 140 is one in which the influence of heat generation of the battery is minimized. Therefore, preferably, the resistance profile may include at least one feature point, so that the charging upper limit SOC corresponding to the C-rate may be determined.

However, if the battery is seriously degraded or if the battery is degraded rapidly, the resistance at each SOC may continuously increase even if it is not due to the heat generation of the battery. In this case, since the resistance profile is a profile that represents the corresponding relationship between SOC and resistance, the resistance profile may not include a feature point.

If the temperature of the battery is controlled during the charging process but the target point cannot be selected from the resistance profile, the control unit 140 may not determine the charging upper limit SOC corresponding to the corresponding C-rate. That is, since the information about the corresponding C-rate is excluded from the charging protocol, the battery may not be charged at the corresponding C-rate according to the charging protocol.

FIG. 8 is a diagram schematically showing a charging control device 200 according to another embodiment of the present disclosure.

Referring to FIG. 8, the charging control device 200 may include a memory 210 and a processor 220.

Specifically, the charging protocol set by the charging protocol setting apparatus 100 may be stored in the memory 210. Then, when the processor 220 needs to control charging of the target battery, the processor 220 may access the memory 210 to obtain the stored charging protocol. Then, the processor 220 may be configured to control charging of the target battery based on the charging protocol.

Preferably, since the charging protocol is a protocol that minimizes the influence of heat generation on the battery, the temperature of the battery to be charged does not need to be specifically controlled during the process in which the charging control device 200 charges the battery to be charged according to the charging protocol.

Meanwhile, the processor 220 included in the charging control device 200 may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the processor 220 may be implemented as a set of program modules. At this time, the program module may be stored in the memory and executed by the processor 220. The memory may be inside or outside the processor 220 and may be connected to the processor 220 by various well-known means.

In addition, the memory 210 included in the charging control device 200 may store data necessary for operation and function of each component of the charging control device 200, data generated in the process of performing the operation or function, or the like. The memory 210 is not particularly limited in its kind as long as it is a known information storage means that can record, erase, update and read data. As an example, the information storage means may include RAM, flash memory, ROM, EEPROM, registers, and the like. In addition, the memory 210 may store program codes in which processes executable by the processor 220 are defined.

Additionally, the charging control device 200 according to the present disclosure may be provided in the battery pack 1. That is, the battery pack 1 according to the present disclosure may include the above-described charging control device 200 and at least one battery cell. Additionally, the battery pack 1 may further include electrical components (relays, fuses, etc.) and a case.

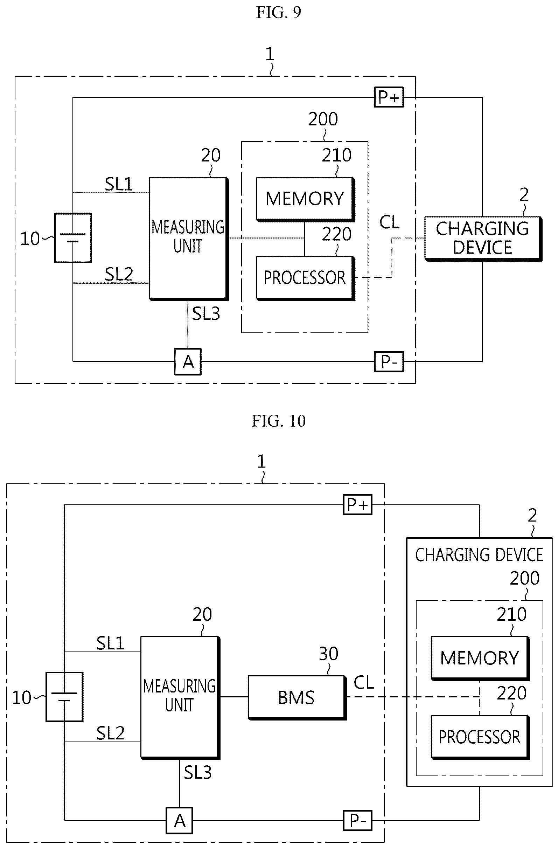

FIG. 9 is a diagram schematically showing a battery pack 1 according to still another embodiment of the present disclosure.

The positive electrode terminal of the battery 10 may be connected to the positive electrode terminal P+ of the battery pack 1, and the negative electrode terminal of the battery 10 may be connected to the negative electrode terminal P- of the battery pack 1.

The measuring unit 20 may be connected to the first sensing line SL1, the second sensing line SL2, and the third sensing line SL3. Specifically, the measuring unit 20 may be connected to the positive electrode terminal of the battery 10 through the first sensing line SL1 and connected to the negative electrode terminal of the battery 10 through the second sensing line SL2. The measuring 20 12 may measure the voltage of the battery 10 based on the voltage measured at each of the first sensing line SL1 and the second sensing line SL2.

Also, the measuring unit 20 may be connected to the current measuring unit A through the third sensing line SL3. For example, the current measuring unit A may be an ammeter or a shunt resistor capable of measuring the charging current and the discharging current of the battery 10. The measuring unit 20 may measure the charging and discharging current of the battery 10 through the third sensing line SL3.

The battery information measured by the measuring unit 20 may be transmitted to the charging control device 200. For example, the measuring unit 20 and the charging control device 200 may be connected to enable wired or wireless communication. The battery information received from the measuring unit 20 may be stored in the memory 210 and input to the processor 220. Additionally, the processor 220 may access the memory 210 to obtain the stored battery information.

The charging device 2 may be connected to the positive terminal P+ and the negative terminal P- of the battery pack 1. Here, the charging device 2 is a device for charging the battery 10.

The processor 220 may be connected to the charging device 2 via a communication line CL to enable wired and/or wireless communication. For example, the processor 220 may perform power-line communication (PLC) with the charging device 2. The processor 220 may determine whether the SOC of the battery 10 has reached the charging upper limit SOC corresponding to the current C-rate based on the charging protocol stored in the memory 210. If the SOC of the battery 10 has reached the charging upper limit SOC, the processor 220 may command the charging device 2 to decrease the C-rate. Preferably, the processor 220 may select a C-rate lower than the current C-rate in the charging protocol, and command the charging device 2 to charge at the selected C-rate.

FIG. 10 is a diagram schematically showing a charging device according to still another embodiment of the present disclosure.

The battery pack 1 may include the battery 10, the measuring unit 20, and the BMS (30, Battery management system). Here, the BMS 30 is a battery management system that diagnoses the state of the battery and controls charging and discharging of the battery. For example, the BMS 30 may be a configuration that has been widely used in the past.

The charging device 2 may include the charging control device 200. For example, the charging device 2 may output the charging current at a C-rate set by the charging control device 200.

The BMS 30 may be connected to the charging device 2 via the communication line CL to enable wired and/or wireless communication. Preferably, the charging device 2 may receive the battery information from the BMS 30. Then, the battery information may be stored in the memory 210 and input to the processor 220. In addition, the processor 220 may access the memory 210 to obtain the stored battery information.

The processor 220 may determine whether the SOC of the battery 10 has reached the charging upper limit SOC corresponding to the current C-rate based on the charging protocol stored in the memory 210. If the SOC of battery 10 has reached the charging upper limit SOC, the processor 220 may reduce the charging C-rate. That is, the processor 220 may reduce the charging current output from the charging device 2. Preferably, the processor 220 may select a C-rate lower than the current C-rate in the charging protocol, and change the C-rate of the charging current output from the charging device 2 to the selected C-rate. Therefore, the charging device 2 may output the charging current corresponding to the lowered C-rate toward the battery 10.

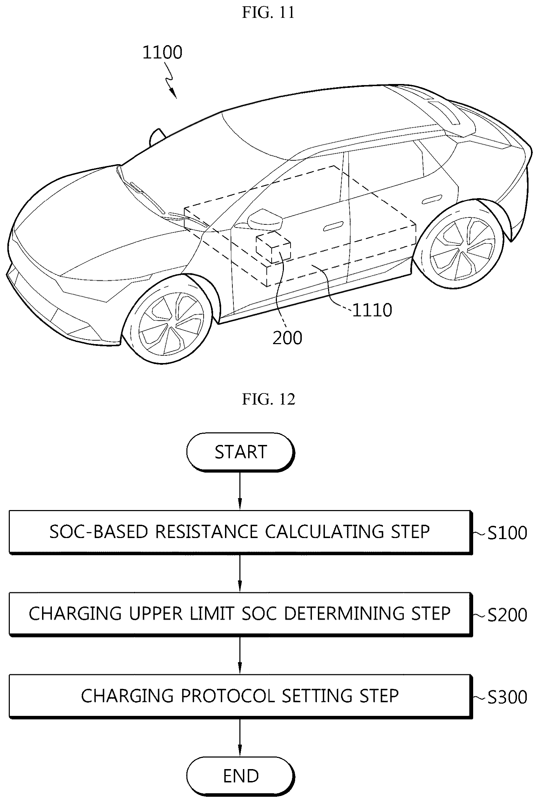

FIG. 11 is a diagram schematically showing a vehicle according to still another embodiment of the present disclosure.

Referring to FIG. 11, the battery pack 1110 according to an embodiment of the present disclosure may be included in a vehicle 1100 such as an electric vehicle (EV) or a hybrid vehicle (HV). Additionally, the battery pack 1110 may drive the vehicle 1100 by supplying power to the motor through an inverter provided in the vehicle 1100. Here, the battery pack 1110 may include the charging control device. That is, the vehicle 1100 may include the charging control device.

FIG. 12 is a diagram schematically showing a charging protocol setting method according to still another embodiment of the present disclosure.

Referring to FIG. 12, the charging protocol setting method may include a SOC-based resistance calculating step (S100), a charging upper limit SOC determining step (S200), and a charging protocol setting step (S300).

Preferably, each step of the charging protocol setting method may be performed by the charging protocol setting apparatus 100. Hereinafter, for convenience of explanation, content that overlaps with the content described above will be omitted or briefly described.

The SOC-based resistance calculating step (S100) is a step of calculating the resistance of the battery at each SOC based on the voltage drop in the rest state while the battery is being charged by repeating the charging state and rest state at a preset first C-rate, and may be performed by the control unit 140.

Specifically, the charging unit 110 may charge the battery based on a command signal received from the control unit 140. In addition, the measuring unit 120 may measure the voltage of the battery while the battery is being charged. The control unit 140 may receive voltage information about the battery from the measuring unit 120, and calculate the resistance of the battery according to the SOC based on the voltage drop during the rest period.

The charging upper limit SOC determining step (S200) is a step of determining the first charging upper limit SOC corresponding to the first C-rate based on the SOC and resistance, and may be performed by the control unit 140.

Specifically, the control unit 140 may generate a resistance profile representing a corresponding relationship between SOC and resistance. Then, the control unit 140 may select a target point from the resistance profile and determine the SOC of the selected target point as a charging upper limit SOC corresponding to the corresponding C-rate.

The charging protocol setting step (S300) is a step for setting a charging protocol including a corresponding relationship between the first C-rate and the first charging upper limit SOC, and may be performed by the control unit 140.

Specifically, the control unit 140 may set a charging protocol by mapping the first C-rate and the first charging upper limit SOC. That is, the charging protocol may include mapping information of the first C-rate and the first charging upper limit SOC.

The charging protocol setting method may perform the SOC-based resistance calculating step (S100), the charging upper limit SOC determining step (S200), and the charging protocol setting step (S300) based on a second C-rate so that a corresponding relationship between the second C-rate different from the first C-rate and a second charging upper limit SOC corresponding to the second C-rate is included in the charging protocol.

Specifically, the control unit 140 may set a charging protocol corresponding to multiple C-rates. That is, the control unit 140 may set a charging protocol representing a corresponding relationship between multiple C-rates and multiple charging upper limit SOCs.

For example, the control unit 140 may include mapping information between the multiple C-rates and the charging upper limit SOC in the charging protocol by performing the SOC-based resistance calculating step (S 100), the charging upper limit SOC determining step (S200), and the charging protocol setting step (S300) for multiple C-rates.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

1: battery pack
2: charging device
10: battery
20: measuring unit
30: BMS
100: charging protocol setting apparatus
110: charging unit
120: measuring unit
130: temperature adjusting unit
140: control unit
150: storage unit
200: charging control device
210: memory
220: processor
1100: vehicle
1110: battery pack

## Claims

1. A charging protocol setting apparatus, comprising:
a charging unit configured to charge a battery so that the battery repeats a charging state and a rest state;
a measuring unit configured to measure a voltage of the battery while the battery is being charged;
a temperature adjusting unit configured to adjust a temperature of the battery while the battery is being charged; and
a control unit configured to control the charging unit so that the battery is charged at a preset first C-rate, calculate a resistance of the battery at each SOC (State of Charge) based on a voltage drop in the rest state, determine a first charging upper limit SOC corresponding to the first C-rate based on the SOC and the resistance, and set a charging protocol including a corresponding relationship between the first C-rate and the first charging upper limit SOC.

2. The charging protocol setting apparatus according to claim 1,
wherein the control unit is configured to control the charging unit so that the battery is charged at a second C-rate different from the first C-rate, determine a second charging upper limit SOC corresponding to the second C-rate for the battery, and include a corresponding relationship between the second C-rate and the second charging upper limit SOC in the charging protocol.

3. The charging protocol setting apparatus according to claim 2,
wherein the second charging upper limit SOC is configured to be lower than the first charging upper limit SOC when the first C-rate is lower than the second C-rate, and to exceed the first charging upper limit SOC when the first C-rate exceeds the second C-rate.

4. The charging protocol setting apparatus according to claim 1,
wherein the temperature adjusting unit is configured to flow a cooling medium so that the temperature of the battery is maintained at a preset threshold temperature or below.

5. The charging protocol setting apparatus according to claim 4,
wherein the measuring unit is configured to further measure a temperature of the battery, and
wherein the temperature adjusting unit is configured to increase at least one of an amount and a flow rate of the cooling medium as the temperature of the battery approaches the threshold temperature.

6. The charging protocol setting apparatus according to claim 1,
wherein the control unit is configured to set a resistance profile representing a corresponding relationship between the resistance and the SOC, select a target point satisfying a predetermined condition in the resistance profile, and determine a SOC corresponding to the selected target point as the first charging upper limit SOC.

7. The charging protocol setting apparatus according to claim 6,
wherein the control unit is configured to select a feature point with a largest corresponding SOC among feature points included in the resistance profile as the target point.

8. The charging protocol setting apparatus according to claim 7,
wherein the control unit is configured to determine a maximum point included in the resistance profile as the feature point.

9. The charging protocol setting apparatus according to claim 6,
wherein the control unit is configured not to determine the first charging upper limit SOC when there is no target point satisfying the predetermined condition in the resistance profile.

10. A charging control device configured to control charging of a battery to be charged based on the charging protocol set by the charging protocol setting apparatus according to any one of claims 1 to 8.

11. A battery pack, comprising the charging control device according to claim 10.

12. A vehicle, comprising the charging control device according to claim 10.

13. A charging protocol setting method, comprising:
a SOC-based resistance calculating step of calculating a resistance of a battery at each SOC based on a voltage drop in a rest state while the battery is being charged by repeating a charging state and the rest state at a preset first C-rate;
a charging upper limit SOC determining step of determining a first charging upper limit SOC corresponding to the first C-rate based on the SOC and the resistance; and
a charging protocol setting step of setting a charging protocol including a corresponding relationship between the first C-rate and the first charging upper limit SOC.

14. The charging protocol setting method according to claim 13,
wherein the SOC-based resistance calculating step, the charging upper limit SOC determining step, and the charging protocol setting step are performed based on a second C-rate different from the first C-rate, so that a corresponding relationship between the second C-rate and a second charging upper limit SOC corresponding to the second C-rate is included in the charging protocol.
